# EUROPÄISCHE PATENTSCHRIFT

(11) **EP 2 601 821 B1**
(45) Veröffentlichungstag und Bekanntmachung des Hinweises auf die Patenterteilung: **27.08.2014**
(21) Anmeldenummer: 11760985.9
(22) Anmeldetag: 13.07.2011
(51) Int. Cl.: H05K 3/06, B41F 15/12

(54) **SIEBDRUCKMASCHINE UND SIEBDRUCKVERFAHREN ZUR HERSTELLUNG VON PLATINEN FÜR DIE ELEKTROINDUSTRIE**
SCREEN PRINTING MACHINE AND SCREEN PRINTING METHOD FOR PRODUCING PRINTED CIRCUIT BOARDS FOR THE ELECTRIC INDUSTRY
MACHINE DE SÉRIGRAPHIE ET PROCÉDÉ DE SÉRIGRAPHIE POUR FABRIQUER DES CARTES DE CIRCUITS IMPRIMÉS POUR L'INDUSTRIE ÉLECTRIQUE

(30) Priorität: 03.08.2010 DE 102010033193
(43) Veröffentlichungstag der Anmeldung: 12.06.2013
(73) Patentinhaber: A&M Kinzel Siebdruckmaschinen Ltd., 33609 Bielefeld (DE); Freudenberg Nok Mechatronics GmbH&Co. KG, 13407 Berlin (DE)
(72) Erfinder: RAUER, Frank, 10318 Berlin (DE)
(74) Vertreter: Brandt, Detlef
(86) Internationale Anmeldenummer: PCT/DE2011/001456
(87) Internationale Veröffentlichungsnummer: WO 2012/016560

(56) Entgegenhaltungen:
- DE-A1- 19 917 794
- US-A- 4 463 673
- US-A- 5 464 662

## Beschreibung

### Technisches Umfeld

Die Erfindung betrifft eine Siebdruckmaschine mit einer Zuführvorrichtung für das zu bedruckende Druckmedium, einem Siebdruckwerk, welches eine Schablonenhalterung und eine Rakelaufnahmevorrichtung aufweist, einer Trockenvorrichtung und einer Abzugsvorrichtung für das Druckmedium.

Darüber hinaus betrifft die Erfindung ein Siebdruckverfahren zur Herstellung von Platinen für die Elektroindustrie durch eine Siebdruckmaschine mit einer Zuführvorrichtung für das Druckmedium, einem Siebdruckwerk, welches eine Schablonenhalterung und eine Rakelaufnahmevorrichtung aufweist, einer Trockenvorrichtung und einer Abzugsvorrichtung für das Druckmedium.

### Stand der Technik

Siebdruckmaschinen der eingangs geschilderten gattungsgemäßen Art sind in der Druckindustrie seit Langem bekannt. Sie werden dort für das Bedrucken unterschiedlicher Druckmedien aus starrem oder flexiblen Material eingesetzt. Die Beschichtung der Druckmedien erfolgt dabei im Wesentlichen dadurch, dass in die Schablonenhalterung eine Druckschablone eingesetzt wird, in denen diejenigen Bereiche, in denen auf das Druckmedium ein Farbauftrag erfolgen soll, ausgespart sind. Nach dem Aufbringen und Fixieren der Druckschablone wird mittels einer in die Rakelaufnahmevorrichtung des Siebdruckwerkes eingesetzte Rakelvorrichtung ein Farbauftrag auf dem Druckmedium vorgenommen. Zu diesem Zweck verfährt die Rakelaufnahmevorrichtung über der Druckschablone und presst in die Aussparungen die für den Druckauftrag vorgesehene Farbmenge.

Eine Siebdruckmaschine mit den gattungsbildenden Merkmalen ist beispielsweise aus der DE 199 17 794 A1 bekannt. Die dort offenbarte Siebdruckmaschine ist mit einer Zufuhrvorrichtung für ein Druckmedium, einem Siebdruckwerk, welches eine Schablonenhalterung und eine Rakelaufnahmevorrichtung aufweist, einer Trocknungsvorrichtung und einer Abzugsvorrichtung für das Druckmedium ausgestaltet.

Auch in der US 5 464 662 A und der US 4 463 673 A werden ähnliche Siebdruckmaschinen beschrieben.

Die beschriebenen Siebdruckmaschinen können sowohl als Flachbettsiebdruckmaschinen mit plattenförmigen Flachbettsiebdruckwerk ausgestaltet sein oder als sogenannte Bogenformatsiebdruckmaschinen, in der der Farbauftrag auf einer trommelförmigen Anordnung für das Druckmedium erfolgt.

Mit den geschilderten Siebdruckmaschinen werden üblicherweise unterschiedlichste Arten von Druckmedien beschichtet.

Aus der Elektroindustrie, einem von der Drucktechnik entfernten arbeitstechnischen Bereich, sind verschiedene Verfahren zur Herstellung von Platinen bekannt.

Platinen sind üblicherweise wie Druckmedien starr oder flexibel ausgebildet und aus nicht leitendem Material hergestellt, auf welches eine Beschichtung aus leitendem Material, vorzugsweise aus Aluminium oder Kupfer, aufgebracht wird. Nach dem Aufbringen der leitenden Beschichtung wird auf diese Beschichtung vollflächig eine lichtempfindliche Schicht aufgebracht.

Um auf dem Druckmedium für die Platinen leitende Bereiche wie zum Beispiel Leiterbahnen zu erhalten, wird nach Aufbringen der belichtungsempfindlichen Beschichtung an den Stellen, an denen die Leiterbahnen auf dem nichtleitenden Material angeordnet sein sollen, eine Belichtung der lichtempfindlichen Schicht durchgeführt. Da die lichtempfindliche Schicht so ausgebildet ist, dass sie sich unter Bestrahlung mit einer UV-Bestrahlungsvorrichtung chemisch derart verändert, dass die belichteten Bereiche eine säurebeständige Struktur erhalten, entsteht durch die Beleuchtung in den beleuchteten Bereichen ein säurebeständiger Überzug über der Kupfer- oder Aluminiumschicht, so dass in einem anschließenden Verfahrensschritt zur Herstellung des fertigen Platinenlayouts lediglich in einem Säurebad, die nicht belichteten Bereiche der lichtempfindlichen Schicht zusammen mit der darunter liegenden leitenden Aluminium- oder Kupferschicht entfernt zu werden brauchen.

### Aufgabe der Erfindung

Aufgabe der vorliegenden Erfindung ist es, zum Einen herkömmlichen Siebdruckmaschinen neue fertigungstechnische Möglichkeiten zu erschließen.

Darüber hinaus soll das oben geschilderte Verfahren zur Herstellung von Platinen für die Elektroindustrie dahin gehend erweitert werden, dass vorhandene produktionstechnische Einheiten für die Herstellung derartiger Platinen genutzt werden können.

Diese Aufgaben werden für eine Siebdruckmaschine mit den gattungsbildenden Merkmalen des Anspruches 1 durch die im kennzeichnenden Teil des Hauptanspruches offenbarte technische Lehre gelöst.

Für das Verfahren zur Herstellung von Platinen für die Elektroindustrie ergibt sich die Erfindung aus den im kennzeichnenden Teil des Anspruches 4 offenbarten Verfahrensschritten.

Hinsichtlich der erfindungsgemäßen Siebdruckmaschine nach Anspruch 1 sieht das wesentliche Merkmal der technischen Lehre vor, dass in die Rakelaufnahmevorrichtung eine UV-Bestrahlungsvorrichtung und in die Schablonenhalterung der Siebdruckmaschine mindestens während einer Bewegung der Rakelaufnahmevorrichtung über ein im Siebdruckwerk befindliches Druckmedium eine Belichtungsschablone eingesetzt ist. Durch diesen Umbau einer herkömmlichen Siebdruckmaschine wird diese in die Lage versetzt, Platinen für die Elektroindustrie aus starrem oder flexiblen Material herzustellen. Das Druckmedium ist zu diesem Zweck, wie oben bereits beschrieben, in herkömmlicher Weise mit einer leitenden Beschichtung und einer darüber angeordneten lichtempfindlichen Schicht versehen und wird, so vorbereitet in das Siebdruckwerk der Siebdruckmaschine durch die Zuführvorrichtung eingebracht.

Anschließend wird die lichtempfindliche Beschichtung an den dafür vorgesehenen Bereichen nach dem Einsetzen einer UV-Beleuchtungseinheit in die Rakelaufnahmevorrichtung durch Verfahren der Rakelaufnahmevorrichtung über dem Siebdruckwerk mit UV-Licht bestrahlt. Durch die UV-Bestrahlung erfolgt eine chemische Veränderung der lichtempfindlichen Schicht in den belichteten Bereichen, so dass säurebeständige Schichtareale entstehen.

Nach der Entnahme des Druckmediums aus dem Siebdruckwerk werden dann die nichtbelichteten Bereiche der Platine zusammen mit der darunter befindlichen Kupferschicht in einem Säurebad entfernt, so dass sich das fertige Platinenlayout ergibt.

Besondere Ausgestaltungen der erfindungsgemäßen Siebdruckmaschine ergeben sich zusätzlich aus den auf den Anspruch 1 rückbezogenen Unteransprüchen. Die Belichtungsschablone ist materialmäßig den speziellen Erfordernissen für die neuartige Verwendung der Siebdruckmaschine dadurch angepasst, dass sie zusammen mit dem Druckmedium während der Belichtung durch die UV-Strahlungsvorrichtung eine Unterstrahlung zwischen der Belichtungsschablone und dem darunter befindlichen Druckmedium verhindert.

Die Gefahr der Unterstrahlung kann zusätzlich entsprechend einer vorteilhaften Weiterbildung der Erfindung dadurch weiter herabgesetzt werden, dass die Belichtungsschablone mindestens während der Bewegung der Rakelaufnahmevorrichtung zusammen mit dem Druckmedium durch eine Ansaugvorrichtung in dem Flachbettsiebdruckwerk fixiert wird.

Die Siebdruckmaschine kann zusätzlich dadurch ergänzt werden, dass die Rakelaufnahmevorrichtung mit einem Schieber versehen ist, welcher an seiner dem Druckmedium zugewandten Unterseite eine Abschlusslippe aufweist.

Durch den Schieber wird die in einem Zwischenraum zwischen Druckmedium und darüber befindlicher Belichtungsschablone vorhandene Luft vor dem Belichten der Belichtungsschablone während der Rückbewegung der Rakelaufnahmevorrichtung in ihre Ausgangsposition ausgepresst.

Das erfindungsgemäße Verfahren zur Herstellung von Platinen für die Elektroindustrie durch eine Siebdruckmaschine mit den im Anspruch 4 angegebenen gattungsgemäßen Merkmalen zeichnet sich erfindungswesentlich dadurch aus, dass nach dem Aufbringen einer leitenden Beschichtung auf einem nichtleitenden Druckmedium, dem anschließenden Aufbringen einer lichtempfindlichen Schicht auf dem leitenden Überzug und dem Einführen des Druckmediums in das Siebdruckwerk der Siebdruckmaschine in die Schablonenhalterung der Siebdruckmaschine eine Belichtungsschablone in die Rakelaufnahmevorrichtung eine UV-Strahlungsvorrichtung eingesetzt wird.

Durch die UV-Strahlungsvorrichtung erfolgt anschließend eine Belichtung der Belichtungsschablone durch Verfahren der Rakelaufnahmevorrichtung. Nach der Abschaltung der UV-Strahlungsvorrichtung und dem Anheben der Schablonenhalterung mit der Belichtungsschablone erfolgt eine Entnahme des Druckmediums aus dem Siebdruckwerk durch die Abzugsvorrichtung.

Anschließend werden die unbelichteten Bereiche der lichtempfindlichen Schicht auf dem Druckmedium zusammen mit der darunter befindlichen leitenden Beschichtung in einem Säurebad entfernt, so dass sich das fertige Platinenlayout ergibt.

Ein zusätzlicher vorteilhafter Verfahrensschritt für das oben beschriebene Siebdruckverfahren ergibt sich dadurch, dass das Druckmedium durch eine Ansaugvorrichtung zusammen mit der Belichtungsschablone mindestens während der Belichtung durch die UV-Strahlungsvorrichtung im Siebdruckwerk fixiert wird. Durch die Fixierung ist gewährleistet, dass während der Beleuchtung der licht-empfindlichen Schicht im Siebdruckwerk eine scharfe Trennung zwischen belichteten und unbelichteten Bereichen erfolgt, die im anschließenden Ätzprozess klar konturierte Kantenbereiche der Leiterbahnen und sonstiger leitenden Bereiche sicherstellt.

Sowohl die erfindungsgemäße Siebdruckmaschine als auch das Verfahren zur Herstellung von Platinen für die Elektroindustrie mittels einer derartigen Maschine besitzt zahlreiche Vorteile, wobei hier insbesondere die geringen Anschaffungskosten für die zusätzliche neue Verwendung zur Herstellung von Platinen auf herkömmlichen Siebdruckmaschinen zu nennen sind. Im Wesentlichen betreffen die Anschaffungskosten lediglich die Bereitstellung einer UV- Bestrahlungsvorrichtung, welche in die Rakelaufnahmevorrichtungen vorhandener Siebdruckmaschinen eingesetzt werden kann.

Die Verwendung herkömmlicher Siebdruckmaschinen beinhaltet naturgemäß natürlich auch, dass kein zusätzlicher Platzbedarf benötigt wird. Größter Vorteil ist allerdings, dass gleiche Vorzug- und Registriersysteme wie in der Folgebearbeitung beispielsweise für das Drucken von Isolierlack sowie weiterer Leiterbahnen oder Beschriftungen der Laminierung von Schutzfolien und dgl. genutzt werden können. Auf diese Weise lassen sich die Gesamtinvestitionen für die Bereitstellung einer geeigneten Produktionsvorrichtung für ein Verfahren zur Herstellung von Platinen für die Elektroindustrie in engen Grenzen halten.

### Figurenbeschreibung

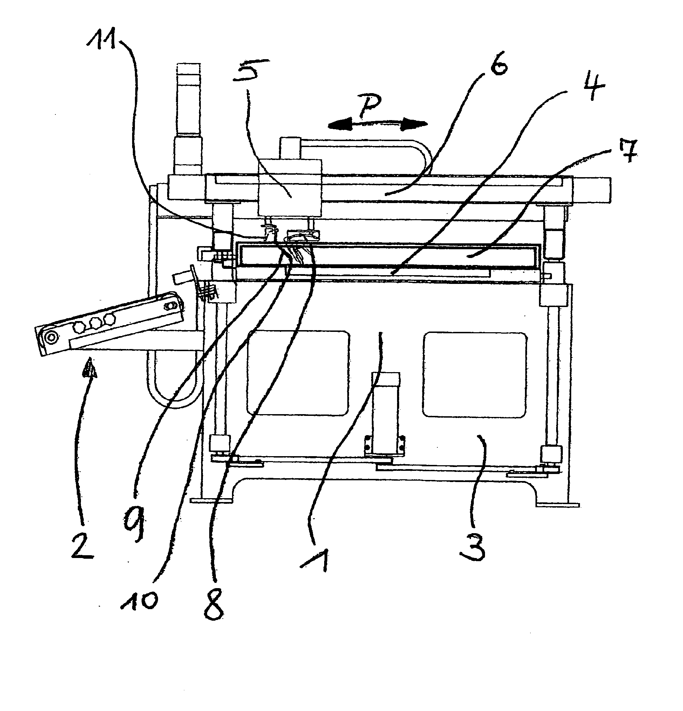

Im Folgenden wird ein Ausführungsbeispiel des Gegenstandes der Erfindung sowie des erfindungsgemäßen Verfahrens anhand der beigefügten Zeichnung näher erläutert.

Die Figur zeigt eine Seitenansicht einer erfindungsgemäßen Siebdruckmaschine. Als Ausführungsbeispiel wurde eine Flachbettsiebdruckmaschine gewählt, wobei auf der beigefügten Abbildung als wesentliche Elemente der Flachbettsiebdruckmaschine das Flachbettsiebdruckwerk, welches insgesamt mit 1 bezeichnet ist, sowie eine zur Maschine gehörende Abzugsvorrichtung 2 für einen aus dem Flachbettsiebdruckwerk herauszutransportierendes Druckmedium abgebildet sind. Zu der Gesamtanlage einer erfindungsgemäßen Siebdruckmaschine gehört darüber hinaus eine Zuführvorrichtung, durch welche das zu bedruckende Druckmedium dem Siebdruckwerk zugeführt wird. Eine derartige Zuführvorrichtung ist aus dem Stand der Technik hinlänglich bekannt und für die erfindungswesentlichen Merkmale der Siebdruckmaschine und des erfindungsgemäßen Verfahrens nicht wesentlich, so dass aus Gründen der Übersichtlichkeit auf die Darstellung in der Zeichnung verzichtet wurde.

Das Flachbettsiebdruckwerk 1 besteht aus einem Maschinengestell 3, an dessen Oberseite ein Siebdrucktisch 4 angeordnet ist. Oberhalb des Siebdrucktisches 4 befindet sich in Doppelpfeilrichtung P verfahrbar eine Rakelaufnahmevorrichtung 5.

Die Rakelaufnahmevorrichtung ist mittels der Verfahreinheit 6 über dem Drucktisch 4 bewegbar. In der Rakelaufnahmevorrichtung 5 befindet sich darüber hinaus ein Antrieb, der eine Vertikalbewegung der Rakelaufnahmevorrichtung 5 ermöglicht.

Zum Flachbettsiebdruckwerk 1 gehört darüber hinaus eine Schablonenhalterung 7, mit deren Hilfe üblicherweise eine Druckschablone über dem zu bedruckenden Medium höhenbewegbar platziert werden kann.

Als erfindungswesentliches neues Element der Siebdruckmaschine ist in der Rakelaufnahmevorrichtung 5 an seiner dem Drucktisch 4 zugewandten Seite eine UV- Strahlungsvorrichtung 8 angeordnet. Die UV- Strahlungsvorrichtung 8 wird an Stelle einer im Siebdruckbau üblicher Rakelvorrichtung in die Rakelaufnahmevorrichtung 5 eingesetzt.

Darüber hinaus befindet sich an der Rakelaufnahmevorrichtung 5 zusätzlich ein Schieber, welcher zusammen mit der Rakelaufnahmevorrichtung 5 mittels der Verfahreinheit 6 über den Drucktisch 4 bewegbar ist. Der Schieber besteht im dargestellten Ausführungsbeispiel aus einem Blechelement 10, welches an seiner unteren, dem Drucktisch 4 zugewandten Seite mit einer aus weichen Stoff bestehenden Abschlusslippe versehen ist.

Die beschriebenen und in der Zeichnung dargestellte Siebdruckmaschine dient auf Grund ihrer innerhalb der Rakelaufnahmevorrichtung 5 angeordneten UV- Strahlungsvorrichtung 8 zur Herstellung von Platinen für die Elektroindustrie. Die für die Herstellung notwendigen Verfahrensschritte werden nachfolgend unter Bezugnahme auf die in der Zeichnung dargestellte Siebdruckmaschine näher erläutert.

Zunächst wird über die nicht näher dargestellte Zuführvorrichtung ein Druckmedium aus starrem oder flexiblen Material auf den Drucktisch 4 befördert. Nachdem das Druckmedium auf dem Drucktisch 4 abgelegt worden ist, wird eine in die Schablonenhalterung 7 eingesetzte Belichtungsschablone auf das Druckmedium abgesenkt. Zur Vorbereitung des nun nachfolgenden Prozesses wurde das Druckmedium zuvor zunächst mit einer leitenden Beschichtung aus Kupfer- oder Aluminiummaterial versehen. Anschließend wurde diese Beschichtung mit einer Schicht aus lichtempfindlichen Lack überzogen. Der lichtempfindliche Lack hat dabei die Eigenschaft, dass er durch Belichtung mit einer UV- Strahlungsvorrichtung an den Stellen, an denen eine Belichtung stattfindet, durch einen chemischen Umwandlungsprozesses eine Säurebeständigkeit erlangt.

Wird also die auf dem Druckmedium insgesamt vorhandene leitende Beschichtung zusammen mit der Lackschicht in ein Säurebad eingetaucht, so wird an den Stellen, an denen keine Belichtung des Druckmediums erfolgt ist, die an diesen Stellen nicht säurebeständige Schicht zusammen mit der darunter liegenden leitenden Beschichtung entfernt. Auf diese Weise ergeben sich auf dem Druckmedium je nach Aussehen der verwendeten Belichtungsschablone Leiterbahnen und andere leitende Bereiche.

Um mit Hilfe einer erfindungsgemäßen Siebdruckmaschine Platinen für die Elektroindustrie herzustellen, ist es somit notwendig, dass vorbereitete Druckmedium im Siebdruckwerk nach dem Aufsetzen der Belichtungsschablone auf das Druckmedium zu belichten. Dies geschieht, indem in die Rakelaufnahmevorrichtung 5 eine UV- Strahlungsvorrichtung 8 eingesetzt wird, die wie eine übliche Rakel in normalen Siebdruckmaschinen über dem Drucktisch verfahrbar ist.

Nach dem Verfahrensschritt des Zuführens des Druckmediums auf den Drucktisch 4 und dem Absenken der Belichtungsschablone auf das Druckmedium werden vorteilhafterweise die übereinander liegenden Elemente mittels einer Ansaugvorrichtung auf dem Drucktisch 4 fixiert. Die Ansaugvorrichtung verbessert die Anpressung zwischen Belichtungsschablone und Druckmedium, so dass während der Beleuchtung der lichtempfindlichen Schicht des Druckmediums auf dem Drucktisch durch die UV- Strahlungsvorrichtung 8 eine Hinterleuchtung der Belichtungsschablone verhindert und eine scharfe Trennung zwischen belichteten und unbelichteten Bereichen erfolgt, die im anschließenden Ätzprozess scharf konturierte Kantenbereiche der Leiterbahnen und der sonstigen leitenden Bereiche sicherstellt.

Nach dem Überfahren der Rakelaufnahmevorrichtung 5 mit der darin angeordneten UV- Strahlungsvorrichtung 8 wird das belichtete Druckmedium anschließend durch die Abzugsvorrichtung 2 und diese unterstützende Elemente vom Drucktisch 4 entfernt.

Anschließend wird durch die Zuführvorrichtung eine neues Druckmedium auf dem Drucktisch 4 platziert. Um nach Auflage des Druckmediums auf den Drucktisch 4 das Anziehen der Belichtungsschablone auf das Druckmedium durch die Absaugvorrichtung zu unterstützen kann es vorteilhaft sein, wenn, wie bereits oben bei der Beschreibung der erfindungsgemäßen Siebdruckmaschine erwähnt, an der Rakelaufnahmevorrichtung 5 ein zusätzlicher Schieber 9 angeordnet ist.

Dieser Schieber 9 dient dazu, die Luft im Zwischenraum zwischen Belichtungsschablone und Druckmedium schnell zu entfernen. Zu diesem Zweck wird nach Aufsetzen der Belichtungsschablone auf das Druckmedium die Rakelaufnahmevorrichtung von ihrer der Abzugsvorrichtung 2 zugewandten Seite wieder in ihre ursprüngliche Anfangsposition verfahren. Dabei drückt der Schieber 9 mit seiner am unteren Ende befindlichen Abschlusslippe 11 aus weichen Stoff oder anderem geeigneten Material von oben auf die Belichtungsschablone und drückt die zwischen dieser und dem Druckmedium befindliche Luft nach allen Seiten aus dem Zwischenraum zwischen den Elementen heraus.

Durch die Anordnung des zusätzlichen Schiebers 9 und den dadurch möglichen Verfahrensschritt wird die mögliche Belichtungsfolge einzelner Druckmedien wesentlich erhöht. Die Anordnung des Schiebers ist dabei als zusätzliche Maßnahme zu sehen, wobei arbeitsablauftechnisch das Zurückfahren der Rakelaufnahmevorrichtung in ihre Anfangsposition zur Belichtung des Druckmediums unabhängig vom Vorhandensein des Schiebers stattfinden muss. Es ist somit konstruktionstechnisch bis auf den Anbau des Schiebers keine weitere verfahrenstechnische Besonderheit bei der Konstruierung der erfindungsgemäßen Siebdruckmaschine zu planen.

### Bezugszeichenliste

- 1: Siebdruckwerk
- 2: Abzugsvorrichtung
- 3: Maschinengestell
- 4: Drucktisch
- 5: Rakelaufnahmevorrichtung
- 6: Verfahreinheit
- 7: Schablonenhalterung
- 8: UV- Strahlungsvorrichtung
- 9: Schieber
- 10: Blechelement
- 11: Abschlusslippe

## Patentansprüche

1. Siebdruckmaschine mit einer Zuführvorrichtung für ein Druckmedium, einem Siebdruckwerk (1), welches eine Schablonenhalterung (7) und eine Rakelaufnahmevorrichtung (5) aufweist, einer Trockenvorrichtung und einer Abzugsvorrichtung (2) für das Druckmedium,
**dadurch gekennzeichnet, dass**
in die Rakelaufnahmevorrichtung (5) eine UV- Strahlungsvorrichtung (8) und in die Schablonenhalterung (7) mindestens während einer Bewegung der Rakelaufnahmevorrichtung (5) über ein im Siebdruckwerk (1) befindliches Druckmedium eine Belichtungsschablone eingesetzt ist.

2. Siebdruckmaschine nach Anspruch 1,
**dadurch gekennzeichnet, dass**
die Belichtungsschablone mindestens während der Bewegung der Rakelaufnahmevorrichtung (5) zusammen mit dem Druckmedium durch eine Ansaugvorrichtung in dem Siebdruckwerk (1) fixiert ist.

3. Siebdruckmaschine nach einem der Ansprüche 1 oder 2,
**dadurch gekennzeichnet, dass**
die Rakelaufnahmevorrichtung (5) mit einem Schieber (9) versehen ist, welcher an seiner dem Druckmedium zugewandten Unterseite eine Abschlusslippe (11) aufweist.

4. Verfahren zur Herstellung von Platinen für die Elektroindustrie durch eine Siebdruckmaschine mit einer Zuführvorrichtung für ein Druckmedium, einem Siebdruckwerk (1), welches eine Schablonenhalterung (7) und eine Rakelaufnahmevorrichtung (5) ausweist, einer Trockenvorrichtung und einer Abzugsvorrichtung (2) für das Druckmedium, **gekennzeichnet durch** folgende Verfahrensschritte:
• Beschichtung eines nichtleitenden Druckmediums mit einem leitenden Überzug
• Aufbringen einer lichtempfindlichen Schicht auf dem leitenden Überzug
• Einführen des Druckmediums in das Siebdruckwerk (1) der Siebdruckmaschine
• Einsetzen einer Belichtungsschablone in die Schablonenhalterung des Siebdruckwerkes (1) und einer UV- Strahlungsvorrichtung (8) in die Rakelaufnahmevorrichtung (5) des Siebdruckwerkes (1)
• Belichtung der Belichtungsschablone **durch** Verfahren der Rakelaufnahmevorrichtung (5) über dem Siebdruckwerk (1)
• Abschaltung der UV- Strahlungsvorrichtung (8)
• Anheben der Schablonenhalterung (7) mit der Belichtungsschablone
• Entnahme des Druckmediums aus dem Siebdruckwerk **durch** die Abzugsvorrichtung (2)
• Entfernen der unbelichteten Bereiche der lichtempfindlichen Schicht auf dem Druckmedium zusammen mit dem darunter liegenden leitenden Überzugsbereich in einem Säurebad

5. Siebdruckverfahren nach Anspruch 4,
**dadurch gekennzeichnet, dass**
das Druckmedium zusammen mit der Belichtungsschablone durch eine Ansaugvorrichtung mindestens während der Belichtung durch die UV-Strahlungsvorrichtung (8) am Siebdruckwerk (1) fixiert wird.

6. Siebdruckverfahren nach einem der Ansprüche 4 oder 5,
**dadurch gekennzeichnet, dass**
in einem Zwischenraum zwischen Druckmedium und darüber befindlicher Belichtungsschablone vorhandene Luft vor dem Belichten der Belichtungsschablone durch mindestens einen an der Rakelaufnahmevorrichtung (5) angeordneten Schieber (9) während der Rückbewegung der Rakelaufnahmevorrichtung (5) in ihre Ausgangsposition ausgepresst wird.

## Claims

1. A screen printing machine having a feed device for a printing medium, a screen printing unit (1) which has a stencil holder (7) and a doctor receiving device (5), a drying device and a removal device (2) for the printing medium,
**characterised in that**
a UV radiation device (8) is inserted into the doctor receiving device (5) and an exposure stencil is inserted into the stencil holder (7) at least during a movement of the doctor receiving device (5) over a printing medium located in the screen printing unit (1).

2. A screen printing machine according to Claim 1,
**characterised in that**
the exposure stencil is fixed in the screen printing unit (1) together with the printing medium by means of a suction device, at least during the movement of the doctor receiving device (5).

3. A screen printing machine according to one of Claims 1 or 2,
**characterised in that**
the doctor receiving device (5) is provided with a slide (9) which has a terminating lip (11) on its lower side facing the printing medium.

4. A process for producing circuit boards for the electrical industry by means of a screen printing machine having a feed device for a printing medium, a screen printing unit (1) which has a stencil holder (7) and a doctor receiving device (5), a drying device and a removal device (2) for the printing medium, **characterised by** the following process steps:
• coating a non-conductive printing medium with a conductive layer
• applying a light-sensitive coating to the conductive layer
• introducing the printing medium into the screen printing unit (1) of the screen printing machine
• inserting an exposure stencil into the stencil holder of the screen printing unit (1) and a UV radiation device (8) into the doctor receiving device (5) of the screen printing unit (1)
• exposing the exposure stencil by moving the doctor receiving device (5) over the screen printing unit (1)
• switching off the UV radiation device (8)
• lifting the stencil holder (7) with the exposure stencil
• extracting the printing medium from the screen printing unit by means of the removal device (2)
• removing the unexposed regions of the light-sensitive coating on the printing medium together with the conductive layer region located beneath it in an acid bath.

5. A screen printing process according to Claim 4,
**characterised in that**
the printing medium is fixed on the screen printing unit (1) together with the exposure stencil by means of a suction device, at least during the exposure by the UV radiation device (8).

6. A screen printing process according to one of Claims 4 or 5,
**characterised in that**,
during the return movement of the doctor receiving device (5) into its starting position, air which is present in a clearance between the printing medium and the exposure stencil located above this latter is pressed out before the exposure of the exposure stencil by means of at least one slide (9) arranged on the doctor receiving device (5).

## Revendications

1. Machine d'impression sérigraphique avec un dispositif d'amenée pour un support d'impression, un groupe d'impression sérigraphique (1) comportant un support de pochoir (7) et un dispositif de réception de racle (5), un dispositif de séchage et un dispositif de retrait (2) pour le support d'impression,
**caractérisée en ce que**
un dispositif d'irradiation UV (8) est placé dans le dispositif de réception de racle (5), et un pochoir d'exposition est placé dans le support de pochoir (7) au moins pendant un déplacement du dispositif de réception de racle (5) au-dessus d'un support d'impression disposé dans le groupe d'impression sérigraphique (1).

2. Machine d'impression sérigraphique selon la revendication 1,
**caractérisée en ce que**
le pochoir d'exposition est fixé par un dispositif d'aspiration avec le support d'impression dans le groupe d'impression sérigraphique (1), au moins pendant le déplacement du dispositif de réception de racle (5).

3. Machine d'impression sérigraphique selon l'une des revendications 1 et 2,
**caractérisée en ce que**
le dispositif de réception de racle (5) est pourvu d'un tiroir (9) qui présente une lèvre de fermeture (11) sur sa face inférieure opposée au support d'impression.

4. Procédé de fabrication de platines pour l'industrie électrique par une machine d'impression sérigraphique avec un dispositif d'amenée pour un support d'impression, un groupe d'impression sérigraphique (1) comportant un support de pochoir (7) et un dispositif de réception de racle (5), un dispositif de séchage et un dispositif de retrait (2) pour le support d'impression, **caractérisé par** les étapes suivantes :
• couverture d'un matériau support non conducteur par un revêtement conducteur
• application d'une couche sensible à la lumière sur le revêtement conducteur
• insertion du matériau support dans le groupe d'impression sérigraphique (1) de la machine d'impression sérigraphique
• mise en place d'un pochoir d'exposition dans le support de pochoir du groupe d'impression sérigraphique (1) et d'un dispositif d'irradiation UV (8) dans le dispositif de réception de racle (5) du groupe d'impression sérigraphique (1)
• exposition du pochoir d'exposition par déplacement du dispositif de réception de racle (5) au-dessus du groupe d'impression sérigraphique (1)
• désactivation du dispositif d'irradiation UV (8)
• soulèvement du support de pochoir (7) avec le pochoir d'exposition
• retrait du matériau support hors du groupe d'impression sérigraphique par le dispositif de retrait (2)
• retrait dans un bain acide des zones non exposées de la couche sensible à la lumière sur le matériau support avec la zone de revêtement conductrice disposée en dessous.

5. Procédé d'impression sérigraphique selon la revendication 4,
**caractérisé en ce que**
le matériau support est fixé par un dispositif d'aspiration avec le pochoir d'exposition contre le groupe d'impression sérigraphique (1), au moins pendant l'exposition par le dispositif d'irradiation UV (8).

6. Procédé d'impression sérigraphique selon l'une des revendications 4 et 5,
**caractérisé en ce que**
l'air présent dans un interstice entre le support d'impression et le pochoir d'exposition disposé sur celui-ci est expulsé avant l'exposition du pochoir d'exposition par au moins un tiroir (9) disposé contre le dispositif de réception de racle (5) pendant le déplacement de retour vers sa position initiale du dispositif de réception de racle (5).
